# EUROPEAN PATENT SPECIFICATION

(11) **EP 3 026 302 B1**
(45) Date of publication and mention of the grant of the patent: **27.06.2018**
(21) Application number: 14828686.7
(22) Date of filing: 26.05.2014
(51) Int. Cl.: F16J 9/26, C23C 14/06, C23C 14/32, F02F 5/00

(54) **PISTON RING AND MANUFACTURING METHOD THEREFOR**
KOLBENRING UND HERSTELLUNGSVERFAHREN DAFÜR
SEGMENT DE PISTON ET PROCÉDÉ DE FABRICATION ASSOCIÉ

(30) Priority: 24.07.2013 JP 2013153392
(43) Date of publication of application: 01.06.2016
(73) Proprietor: Kabushiki Kaisha Riken, Chiyoda-ku, Tokyo 102-8202 (JP)
(72) Inventor: TSUJI, Katsuhiro, Kashiwazaki-shi Niigata 945-8555 (JP)
(74) Representative: Weickmann & Weickmann PartmbB
(86) International application number: PCT/JP2014/063840
(87) International publication number: WO 2015/011982

(56) References cited:
- EP-A1- 2 587 518
- JP-A- 2004 137 535
- JP-A- 2005 002 888
- JP-A- 2006 057 674
- JP-A- 2007 232 026
- JP-A- 2007 501 331
- JP-A- 2008 241 032
- JP-A- 2009 545 670

## Description

### Field of the Invention

The present invention relates to a piston ring on which a hard carbon coating is formed that is used by mounting to an aluminum alloy piston, and a method of producing the same.

### Description of the Related Art

In recent years, internal combustion engines including an automobile engine require a fuel consumption improvement as well as high output characteristics and a long life. In particular, in order to convert dilatational energy of a fuel gas into kinetic energy efficiently, a piston ring for sealing a high-pressure gas upon combustion is exposed to a more severe use environment. For example, if a compression ratio of the fuel gas increases in order to improve a thermal efficiency of the internal combustion engine, a temperature of a combustion chamber increases. Also, in order to improve a fuel consumption, a friction loss between the piston ring and an inner wall of a cylinder liner should be decreased. A compression ring of the piston ring is trying to decrease its width. In addition, the durability of the piston ring is required.

When the piston ring is mounted to a piston ring groove of an aluminum alloy piston, a temperature of the piston increases as the temperature of the combustion chamber increases. Aluminum of the piston is adhered to a side surface of the piston ring that slides with the piston ring groove. Sealing characteristics may decrease, and an oil consumption amount may increase. Therefore, the side surface of the piston ring used in the aluminum alloy piston is required to have a function to inhibit the adhesion of aluminum.

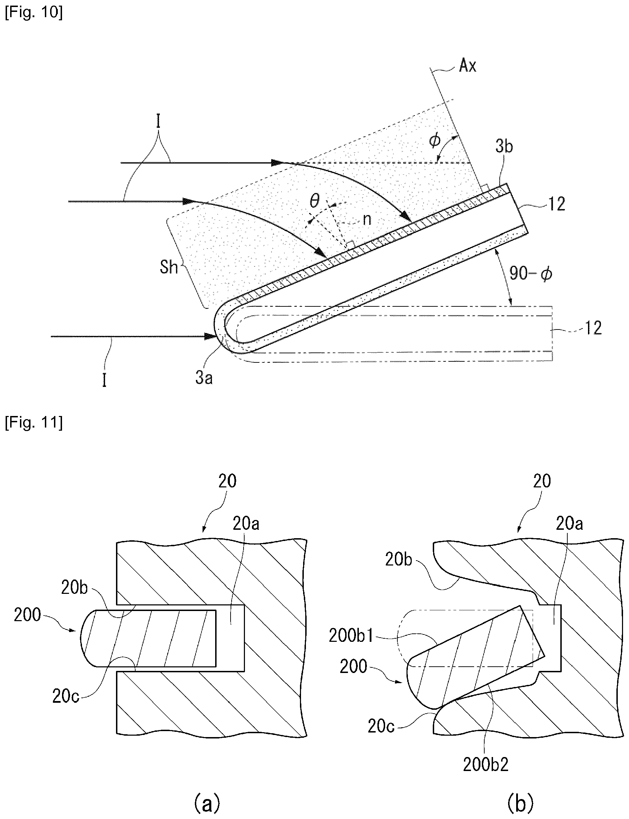

Along with the decreased width of the piston ring (compression ring) as described above, so-called "trumpet-shaped abrasion" that the piston ring groove wears such that the groove widens in an axial direction occurs, as shown in Fig. 11.

Fig. 11 shows that a piston ring (top ring) 200 is mounted to a piston ring groove 20a of a piston 20. While the piston 20 is used from an initial state(Fig. 11a), a lower side surface 200b2 of the top ring 200 is pressed against a second land 20c of the piston ring groove 20a in the state that the lower side surface 200b2 is tilted against a horizontal plane by a pressure of a combustion gas. Also, an upper side surface 200b1 of the top ring 200 is also pressed against a top land 20b of the piston ring groove 20a by a reciprocating motion of the piston 20. It causes the "trumpet-shaped abrasion" that the piston ring groove 20a widens in an axial direction.

At this time, as the upper side surface 200b1 and the lower side surface 200b2 of the top ring 200 wear, the technology that a hard carbon coating having excellent abrasion resistance is formed on an outer periphery and a side surface of a piston ring has been proposed.

For example, Patent Literature 1 describes that diamond-like carbon where 5 to 40 atom% of one or two or more elements selected from the group consisting of Si, Ti, W, Cr, Mo, Nb and V are dispersed and a coating hardness is within HV 700 to 2000 is formed on a side surface of a piston ring.

Patent Literature 2 describes that a hard carbon film having a dense structure is formed at a periphery of a piston ring, and a hard carbon film having a columnar structure is formed at a side surface of the piston ring, each hard carbon film containing 1 atom% to 10 atom% of oxygen, 10 atom% to 40 atom% of hydrogen and 0.1 atom% to 20 atom% of silicon.

### Prior Art Literature

### [Patent Literature]

[Patent Literature 1] Japanese Patent 3355306
[Patent Literature 2] Japanese Unexamined Patent Publication (Kokai) 2008-241032

### Summary of the Invention

### [Problems to be solved by the Invention]

If a piston ring is mounted to an aluminum alloy piston and a cylinder liner containing Fe as a main component slides with the piston ring, sliding state of an outer periphery and a side surface of the piston ring are different. Therefore, coating characteristics required for the piston ring are different in the outer periphery and in a side surface. Specifically, as the outer periphery of the piston ring is exposed to more severe sliding environment as compared with the side surface, the outer periphery requires a high abrasion resistance. On the other hand, the side surface of the piston ring requires an abrasion resistance against sliding with the aluminum alloy and less adhesion to aluminum at a piston side.

However, in the technology described in Patent Literature 1, as the same hard carbon coatings are formed on the outer periphery and the side surface of the piston ring, it is difficult to provide the outer periphery with a sufficient abrasion resistance for a long period of time because the outer periphery of the piston ring is exposed to more severe sliding environment as compared with the side surface.

In the technology described in Patent Literature 2, as the hard carbon coatings contain hydrogen, the coatings have a low thermal resistance, a gas is released from the coating due to a thermal decomposition upon exposure to the combustion gas at high temperature, and the coating is easily exhausted by oxidation.

The present invention is to solve the above-described problems. An object is to provide a piston ring that can provide different coating characteristics on an outer periphery and a side surface thereof, hold abrasion resistance for a long period of time, and inhibit the adhesion of aluminum of a piston ring groove.

### [Means for Solving the Problems]

To achieve the above object, the present invention provides a piston ring mounted to a piston made of an aluminum alloy that slides with a cylinder liner containing Fe as a main component according to claim 1, comprising: hard carbon coatings containing no hydrogen formed on an outer periphery and at least one side surface, the hard carbon coating formed on the outer periphery having no columnar structure, and the hard carbon coating formed on the side surface having a columnar structure extending to a direction intersecting with the side surface.

The hard carbon coating at the outer periphery is disposed at an outer periphery side of the piston ring, slides with the cylinder liner containing Fe as the main component, and is therefore requires a high abrasion resistance. As the outer periphery of the hard carbon coating has no columnar structure, the coating becomes dense, thereby providing a good abrasion resistance, and maintaining the abrasion resistance for a long period of time.

On the other hand, as the hard carbon coating formed at the side surface has a columnar structure, a lubricant is permeated into the columnar structure from the surface of the hard carbon coating and held therein, whereby oil is not easily lost. As a result, even if the side surface of the piston ring groove of the aluminum alloy piston slides with the side surface (hard carbon coating) of the piston ring, aluminum is less adhered.

Furthermore, the columnar structure of the hard carbon coating is formed in a direction tilted to the outer periphery side from a normal direction, the direction into which the columnar structure is extended will be closer to (along with) a direction of a resultant force of pressing, when the columnar structure is pressed to a second land of the piston ring while the hard carbon coating is tilted. As a result, a force trying to shear the columnar structure in a direction intersecting with a boundary in the columnar structure (in a direction parallel to the side surface) is reduced, thereby providing a good abrasion resistance of the columnar structure (hard carbon coating).

The columnar structure extends to a direction tilted at 10 to 30 degrees to the outer periphery from a normal direction of the side surface.

Preferably, the hard carbon coating contains 98 atom% or more of carbon.

The present invention provides a method of producing a piston ring according to claim 3, comprising: forming hard carbon coatings on an outer periphery and at least one side surface of the piston ring using an arc type evaporation source including a carbon cathode by an arc ion plating method, wherein the side surface of the piston ring and an ion flow from the arc type evaporation source are disposed to have an angle therebetween of 10 to 40 degrees, and the hard carbon coatings are formed without feeding gas from outside excluding an inert gas. A pressure upon the formation of the hard carbon coatings is 5 x 10⁻² Pa or less.

### Effects of the Invention

According to the present invention, different coating characteristics can be added to an outer periphery and a side surface of a piston ring, abrasion resistance can be held for a long period of time, and the adhesion of aluminum to a piston ring groove can be inhibited.

### Brief Description of the Drawings

[Fig. 1] A sectional view of a piston ring according to an embodiment of the present invention.
[Fig. 2] A view showing a sectional SEM image of a hard carbon coating formed on an outer periphery of a sample in Example 1.
[Fig. 3] Views each showing a sectional SEM image of a hard carbon coating formed on a side surface of a sample in Example 1.
[Fig. 4] A view showing a contour image extracted from a columnar structure from the sectional SEM image in Fig. 3.
[Fig. 5] A schematic view showing that a hard carbon coating formed on a side surface of a piston ring is pressed against a piston ring groove having trumpet-shaped abrasion.
[Fig. 6] A sectional view showing an alternative embodiment of a piston ring according to an embodiment of the present invention.
[Fig. 7] A sectional view of a jig for holding a base of the piston ring.
[Fig. 8] A perspective view showing a plate for holding the piston ring.
[Fig. 9] A sectional view showing a film formation apparatus for forming the hard carbon coating.
[Fig. 10] A view showing a process for forming the hard carbon coating on the base.
[Fig. 11] Schematic views showing a state that the trumpet-shaped abrasion is induced on the piston ring groove.

### Description of the Embodiments

Hereinafter, embodiments according to the present invention will be described.

The piston ring according to an embodiment of the present invention is mounted to a piston ring groove of an aluminum alloy piston and slides with a cylinder liner containing Fe as a main component.

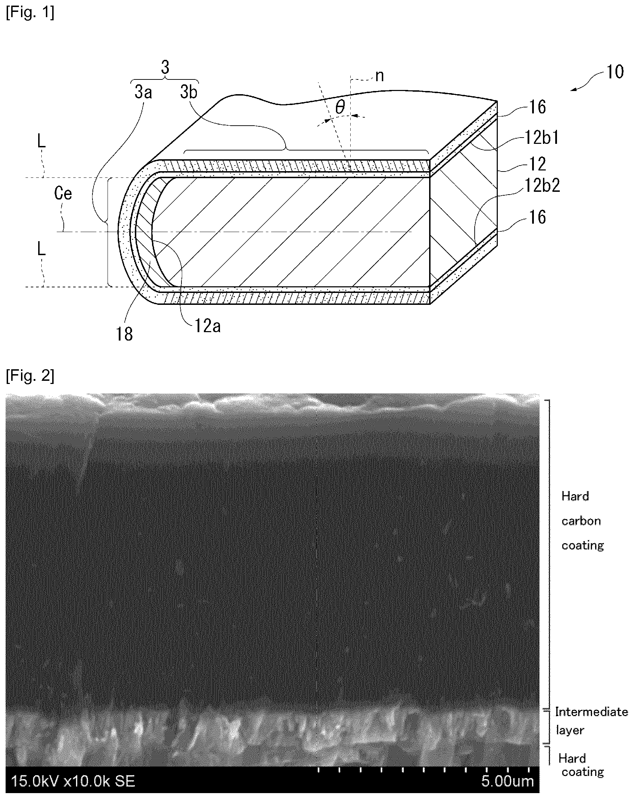

Fig. 1 is a sectional view of a piston ring 10 according to an embodiment of the present invention. The piston ring 10 includes a hard carbon coating 3 formed on an outer periphery 12a and each side surface 12b1, 12b2 of a base 12. Here, the "side surface" of the piston ring 10 is a plate surface of the piston ring 10, and the "outer periphery" is a surface adjacent to and intersecting with the "side surface". As shown in Fig. 1, the "outer periphery" may be preferably round (barrel shaped), but may have any shape that is applicable to the outer periphery of the piston ring. The hard carbon coating formed on the outer periphery 12a is represented as "3a", and the hard carbon coatings formed on the side surfaces 12b1, 12b2 are represented as "3b".

The boundary between the hard carbon coatings 3a, 3b is not necessarily clear. The hard carbon coating 3b includes a part in parallel with each of side surfaces 12b1, 12b2 in an outer radial direction (a left side in Fig. 1) being an inner diameter side (a right side in Fig. 1) of the piston ring 10 as a starting point. On the other hand, the hard carbon coating 3a includes a part from a center Ce to each of the side surfaces 12b1, 12b2 viewed at least in a thickness direction of the base 12.

The base 12 may be stainless steel, steel, cast iron, cast steel or the like.

In this embodiment, a hard coating 18 is formed on the outer periphery 12a of the base 12. An intermediate layer 16 is formed between the hard carbon coating 3a and the hard coating 18, and the intermediate layer 16 is formed between the hard carbon coating 3b and both side surfaces 12b1, 12b2.

The intermediate layer 16 is configured of one or two or more of those selected from the group consisting of chromium, titanium, tungsten, silicon carbide and carbide tungsten, and improve the adhesiveness between the base 12 and the hard carbon coating 3.

The hard layer 18 is configured of a chromium nitride layer or titanium nitride layer formed by a physical vapor deposition method (PVD method); chromium plating layer; a composite chromium plating layer containing hard particles in chromium plating; a thermal spraying layer; a nitride layer, etc., maintains the abrasion resistance of the periphery of the piston ring used under a severe sliding environment, and improves the durability.

Note that the intermediate layers 16 and the hard layer 18 are not essential.

As the hard carbon coating 3 contains no hydrogen, the coating has excellent thermal resistance, is less thermally decomposed upon exposure to a combustion gas at high temperature, and is inhibited from consuming by oxidation.

If the hard carbon coating 3 contains 98 atom% or more of carbon, impurity elements other than carbon are less included in all components of the hard carbon coating 3.

Contents of hydrogen and carbon of the hard carbon coating are evaluated by RBS (Rutherford Backscattering Spectrometry)/HFS (Hydrogen Forward Scattering Spectrometry) and SIMS (Secondary Ion Mass Spectrometry). A detailed method of measurement will be described later.

The hard carbon coating 3a formed on the outer periphery 12a of the piston ring has no columnar structure. The hard carbon coating 3a is disposed at the outer periphery side of the piston ring 10, slides with a cylinder liner containing Fe as a main component, and requires a high abrasion resistance. By forming the hard carbon coating 3a having no columnar structure, the coating becomes dense, thereby providing a good abrasion resistance, and maintaining the abrasion resistance for a long period of time.

Here, the coating having no columnar structure refers to a coating having a section morphology where the columnar structure is not observed by a SEM (Scanning Electron Microscope) image (secondary electron image) of a fracture surface on the hard carbon coating provided by the method as described later. When the fracture surface on the coating is produced, a notch, a groove, a cutout, or the like is formed at a base side opposite to the coating so that a structure morphology of the coating is not changed, and the coating is cut from the base side to enlarge or reduce the notch or the like.

Fig. 2 shows a sectional SEM image of the hard carbon coating 3a formed on the outer periphery of a sample in Example 1 as described later.

On the other hand, the hard carbon coating 3b formed at each of the side surfaces 12b1, 12b2 of the piston ring 10 has the columnar structure tilted at the outer periphery in a radial direction against a normal direction of the side surfaces (a central axis of the piston ring) (diagonal lines in Fig. 1 represent a boundary of structures). In this manner, a lubricant is infiltrated from the surface of the hard carbon coating 3b to interspaces between the columnar structures and held therein, whereby oil is not easily lost. As a result, when a wall surface of the piston ring groove of the aluminum alloy piston slides with the side surfaces (hard carbon coating 3b) of the piston ring 10, aluminum is less adhered.

In particularly, as shown in Fig. 1, the columnar structure extends to a direction tilted at an angle θ of 10 to 30 degrees to the outer periphery from a normal direction n of the side surfaces 12b1, 12b2.

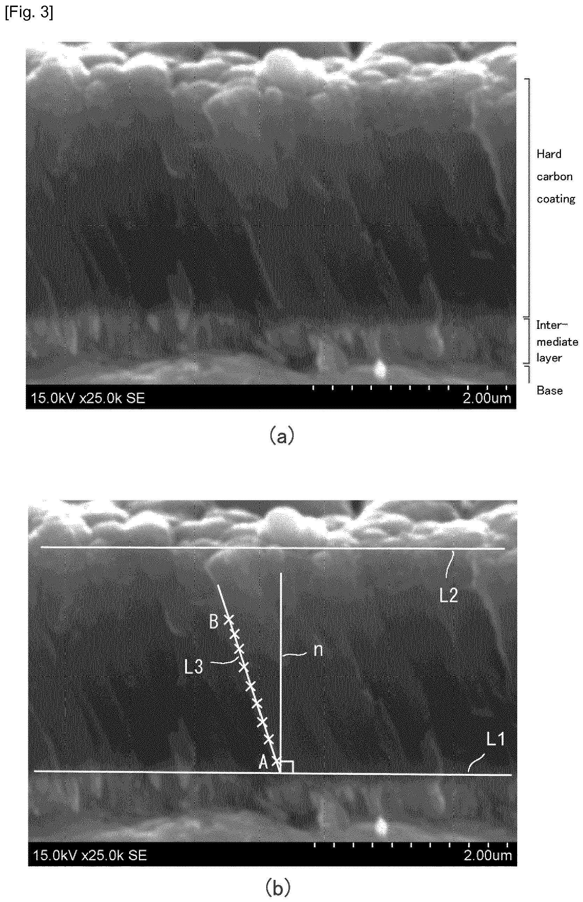

Presence or absence of the columnar structure and the angle θ are determined by the following procedures:
A sample having the fracture surface along the radial direction of the hard carbon coating 3b is prepared. Using the scanning electron microscope (SEM), the secondary electron image of the sample at x20000 to 30000 magnification is acquired (see Fig. 3 (a)). A contrast of the SEM image of the hard carbon coating 3b is different from that of the lower base (or the intermediate layer). Therefore, a predetermined threshold value is provided for the contrast of the hard carbon coating 3b. A linearly approximated line of a boundary brighter than the threshold value is defined as a boundary line L1 between the hard carbon coating 3b and a lower layer (see Fig. 3 (b)). The boundary is determined by providing the contrast for 10 points in a lateral direction of the hard carbon coating 3b (in a left and right direction in Fig. 3 (b)). As to a boundary line L2 on an upper surface of the hard carbon coating 3b is determined in the same manner.

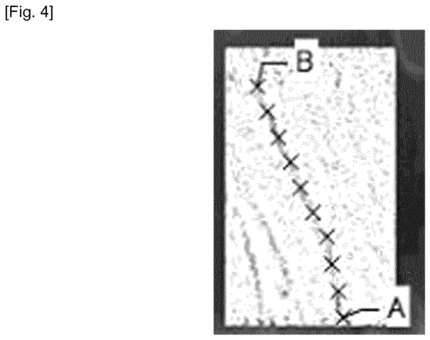

In addition, in the secondary electron image, an edge of the columnar structure is highlighted and becomes bright. Therefore, when a part of the hard carbon coating 3b in the secondary electron image is image-processed and a contour is extracted as shown in Fig. 4, the edge of the columnar structure appears as a black line. Along the edge of the columnar structure extracted in Fig. 4 and from the boundary line L1 to upward in Fig. 3 (a), 10 points are picked up from areas A to B exceeding half of the height, i.e., the space between the boundary lines L1 and L2 (corresponds to a film thickness of the hard carbon coating 3b). A straight line L3 passing through the 10 points is determined by the least-squares method.

Then, an angle θ between a normal line n perpendicular to the boundary line L1 and the straight line L3 is determined. Furthermore, from the contour extracted image in Fig. 4, a straight line L3 is provided from 10 points. θ of the straight line L3 is arithmetically averaged, which is used as a slope θ of the columnar structure.

If there is no black line extending above half of the height, i.e., the space between the boundary lines L1 and L2 by extracting the contour in Fig. 4, it will be concluded that the hard carbon coating has "no columnar structure". In other words, the "coating including no columnar structure" refers to a coating having no line after the contour is extracted as described above, or a coating having a length of the line L3 less than half of the space between (film thickness of) the boundary lines L1 and L2.

Note that, in the SEM image at a high magnification exceeding x30000 magnification, a line showing a boundary of a closed area may be provided by the contour extraction processing. Such a line is not a narrow and long line like the straight line L3 showing the boundary of the columnar structure. Therefore, in order to distinguish from the boundary of the columnar structure, the straight line L3 is defined by an aspect ratio of 5 or more. The aspect ratio is a ratio of a long diameter to a short diameter. The contour image having the aspect ratio of less than 5 is not acquired.

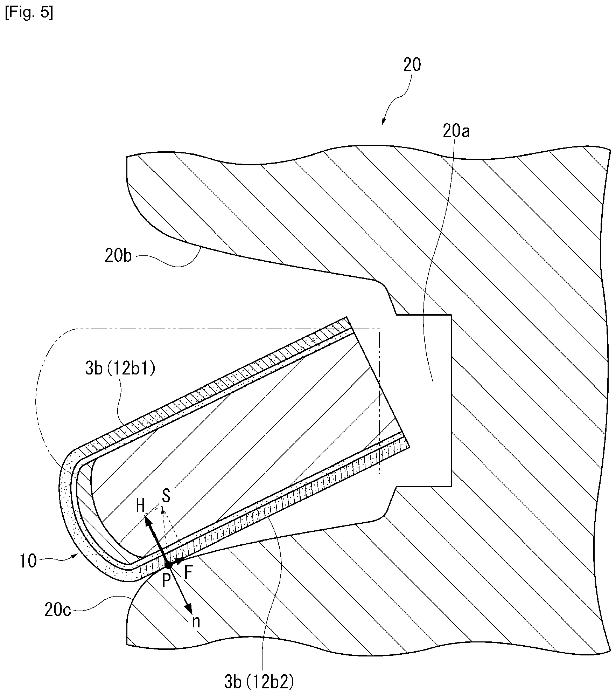

Next, referring to Fig. 5, the reason why θ is 10 to 30 degrees in the columnar structure will be described. As shown in Fig. 5, under the state that the "trumpet-shaped abrasion" is induced on the piston ring groove 20a, the side surface 12b2 of (the hard carbon coating 3b formed on) the piston ring 10 is pressed against the second land 20c in a tilted state by a pressure of a combustion gas and so on. At this time, a normal force H that repels the pressing force and a frictional force F in a direction parallel to the side surface 12b2 act on a point P of the hard carbon coating 3b. A resultant force S of the normal force H and the frictional force F acts on the hard carbon coating 3b in a direction tilted to an inner diameter side from the normal line n.

Then, by forming the columnar structure of the hard carbon coating 3b extending in a direction tilted to an outer periphery side from a normal line n direction, the direction to which the columnar structure extends will be close (along) the direction of the resultant force S. As a result, a force trying to shear the columnar structure in a direction intersecting with the boundary of the columnar structure (in a direction in parallel with the side surfaces 12b1, 12b2) is decreased, and the abrasion resistance of the columnar structure (hard carbon coating 3b) becomes better. The columnar structure is tilted at 10 to 30 degrees to the outer periphery side from the normal line of a base surface of the piston ring. In contrast, if θ equals 0, a shear force by the resultant force I applied on the columnar structure tends to be great.

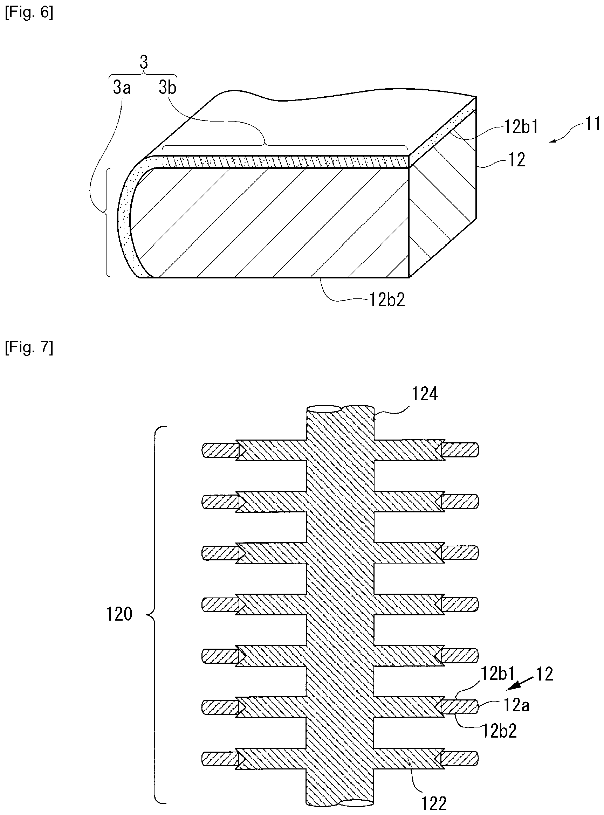

Alternatively, as shown in Fig. 6, the hard carbon coating 3b may be formed on only one of the side surfaces 12b1, 12b2.

The base 12 may be masked in order not to form the hard carbon coating 3. Or, the side surfaces of the base 12 where no hard carbon coating is formed may be overlapped in order not to form the hard carbon coating. Alternatively, after the hard carbon coating 3 is formed, the hard carbon coating 3 may be polished to remove unnecessary hard carbon coating 3.

The piston ring according to the present invention is mounted to a piston made of an aluminum alloy. A cylinder liner to which the piston is applied contains Fe as a main component. The piston ring according to the present invention slides with the cylinder liner. Herein, the term "Fe as a main component" refers to a metal containing 50 wt% or more of Fe. Examples of the metal include a common steel composition such as cast iron, boron cast iron and cast steel.

Next, referring to Fig.7 to Fig. 10, a method of producing the piston ring according to an embodiment of the present invention will be described.

Fig. 7 is a sectional view of a jig 120 holding each base 12 of the piston ring before the formation of the hard carbon coating 3. The jig 120 includes a center axis 124 and a plurality of plates 122 for holding the piston ring. The respective plates 122 for holding the piston ring are apart each other in a thickness direction and, are connected to the center axis 124 so that their centers are concentric with the center axis 124.

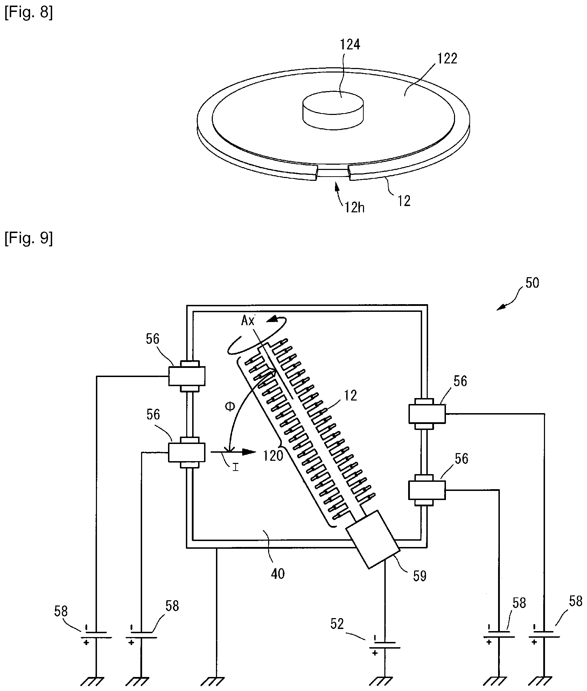

In addition, as shown in Fig. 8, the plate 122 for holding the piston ring has a disk shape having a diameter somewhat greater than an inner diameter of the base 12. The base 12 is mounted to the plate 122 for holding the piston ring such that a rim of the plate 122 for holding the piston ring is surrounded by the base 12. The base 12 is held by the plate 122 for holding the piston ring due to a spring property of the base 12 by reducing the diameter of the base. End gaps 12h of the respective bases 12 are aligned in the same direction within the jig 120.

In this way, an inner diameter or the side surface on which no coating is formed of the base 12 is preferably held in order not to inhibit a motion of an ion flow I as described later.

The hard layer 18 may be formed at the outer periphery of the base 12.

Fig. 9 shows a film formation apparatus 50 for forming the hard carbon coating 3. The film formation apparatus 50 is an arc ion plating apparatus having a cathode discharge arc type evaporation source including carbon cathodes. The film formation apparatus 50 includes a vacuum chamber 40, carbon cathodes 56 disposed on faced wall surfaces of the vacuum chamber 40, arc discharge power sources 58 connected to the carbon cathodes 56, the above-described jig 120 disposed within the vacuum chamber 40, a motor 59 for rotating the jig 120 around an axis center Ax, and a bias power source 52 connected to the jig 120.

In order to form the hard carbon coating 3 containing no hydrogen by the arc ion plating method, it is required to use the carbon cathodes and gas having a molecular formula containing no hydrogen (for example, inert gas such as argon) as gas in a film forming atmosphere. The film forming atmosphere may be a high vacuum atmosphere to which no gas is introduced. In other words, when the hard carbon coating 3 is formed, the film is formed without introducing hydrogen or molecular components containing hydrogen as a constituent element from outside except for a moisture adsorbed on an inner wall of the film forming chamber and gas components that are unavoidably flowed into a film forming chamber due to a leak of the film forming chamber. As a result, the hard carbon coating 3 containing no hydrogen can be formed.

Herein, the term "containing no hydrogen" refers that a hydrogen content is 2 atom % or less when a total amount of all elements configuring the hard carbon coating 3 is taken as 100 atom %.

According to the present embodiment, the axis center Ax of the jig 120 is tilted at an angle ϕ (ϕ < 90 degrees) to a direction of the ion flow I from the carbon cathode 56. In this manner, the angle θ where the columnar structure of the hard carbon coating 3b extends can be 10 to 30 degrees, as described later.

Fig. 10 is a view showing a process for forming the hard carbon coating 3 on the base 12. Once the carbon cathodes are evaporated by arc discharge, carbon is ionized and collided with electrons and gas, thereby generating plasma and forming the ion flow I, which flows into the base 12 held by the jig 120. Under the state, the film is formed by rotating the jig 120 around the axis center Ax.

Here, as the outer periphery 12a of the base 12 faces to the ion flow I, carbon ions directly arrive at and are deposited on the outer periphery 12a, and the hard carbon coating 3a having a section morphology including no columnar structure is formed.

On the other hand, both side surfaces 12b1, 12b2 of the base 12 are tilted at an angle smaller than the right angle to the ion flow I. Around the base 12 in plasma, a sheath electric field Sh is generated by a difference between electron mobility and ion mobility. In general, a negative bias is applied. Even though no bias is applied (at 0V or a floating potential), the base 12 has a negative potential to a plasma potential so that carbon ions are drawn (roundabout) to both side surfaces 12b1, 12b2.

At ϕ > 0 degree, both side surfaces 12b1, 12b2 are tilted at an angle of (90-ϕ) degrees to the ion flow I. The ion flow I becomes closer to a direction in parallel with the normal direction n of the side surfaces. As a result, the columnar structure may be grown at θ of 10 to 30 degrees.

The temperature upon the film formation is preferably 200°C or less, more preferably 160°C or less. If the film formation temperature exceeds 200°C, the coating formed may be graphitized and the strength may be lowered.

As in Comparative Example 4 as described later, when an inert gas such as Ar is introduced upon the film formation to increase a pressure of atmosphere, the carbon ions are collided with the gas, are dispersed and are roundabout the both side surfaces 12b1, 12b2, and θ is decreased. However, in this case, as the carbon ions are collided with the gas and the energy is lost, coating hardness (abrasion resistance) is decreased.

At ϕ = 50 to 80 degrees, the abrasion resistance of the hard carbon coating 3 is preferably improved. At ϕ > 80 degrees, an approaching angle of the ion flow I arrived at the both side surfaces 12b1, 12b2 is shallower (θ is much greater), and it is difficult to provide sufficient abrasion resistance. Herein, the approaching angle refers to a minimum angle between the both side surfaces 12b1, 12b2 and the direction of moving carbon.

On the other hand, at ϕ < 50 degrees, a plurality of the bases 12 stacked on the jig 120 forms an obstacle and the ion flow I is therefore blocked frequently. This may decrease a contribution ratio of the ion flow I having high energy to the coating formation, it becomes difficult to form the hard carbon coating 3, and the quantity of the bases 12 disposed within the film formation apparatus 50, thereby decreasing the productivity. At ϕ = 50 to 80 degrees, a kinetic energy in the normal direction n component of the ion flow I which comes to the surface of the base 12 increases, and the carbon ions are collided with and deposited on the both side surfaces 12b1, 12b2 of the base 12 with higher energy. As a result, the columnar structure with θ = 10 to 30 degrees is reliably provided, and the sliding characteristics become better.

Alternatively, the surfaces of the carbon cathodes 56 may be disposed obliquely to the axis center Ax without tilting the axis center Ax instead of tilting the axis center Ax of the jig 120 at the angle ϕ to the direction of the ion flow I as described above.

When gas is not intentionally introduced from outside at the film formation, leak gas or discharged gas that is adsorbed on an inner wall of the film forming chamber 40 before the film formation may unavoidably increase the pressure of the vacuum chamber 40 upon the film formation. Then, if the pressure upon the film formation is 5 x 10⁻² Pa or less, the ion flow I is less collided with atoms (or molecules) of the gas. The ion flow I does not lose initial energy, and goes easily straight. The orbit of the ion flow I going straight is bent by the action of the sheath electric field Sh, thereby preferably forming stably the hard carbon coating 3b having the inclined columnar structure.

In addition, in order to decrease droplets discharged from the carbon cathodes by the arc discharge and to inhibit the same from entering into the coating, arc discharge current is preferably lowered and a mechanism for removing the droplets is preferably provided. For the mechanism for removing the droplets, a filter or screen for magnetic field transportation that can sort the droplets may be used. In this case, although a film formation rate is decreased, the resultant hard carbon coating 3 has excellent smoothness, which makes smoothing of the surface of the coating after the film formation unnecessary or easy.

### Examples

### (Example 1 to Example 4, Comparative Example 1 and Comparative Example 2)

The outer periphery of the base 12 (top ring made of spring steel, nominal diameter: ϕ78 mm, ring height (h1): 1.2 mm, ring width (a1): 2.4 mm) of the piston ring material was polished in the axial direction such that the surface roughness Rzjis was 0.3 to 0.5 µm. Similarly, the side surfaces of the base 12 were polished such that the surface roughness Rzjis was 0.8 to 1.2 µm. Rzjis is specified in JIS B0602:2001. After the polishing, the base 12 was washed to remove dirt attached on the surface.

Next, each base 12 was mounted to the jig 120 of the film formation apparatus 50 shown in Fig. 7 and Fig. 9. The jig 120 was washed in advance. The end gap 12h of each base 12 was aligned in the same direction within the jig 120. The vacuum chamber 40 of the film formation apparatus 50 was vacuum-evacuated to a pressure of 5 x 10⁻³ Pa or less by a vacuum evacuation mechanism. At this time, the temperature of the vacuum chamber 40 was increased, and the vacuum chamber 40 was held at a predetermined temperature.

After the vacuum evacuation, ion bombardment was performed on each base 12. Thereafter, the intermediate layer 16 made of chromium was formed on the surface of the base 12 (see Fig. 1). Next, while the carbon cathodes 56 (99 at% or more of carbon) were evaporated by the arc discharge, the hard carbon coating 3 was formed on the surface of each base 12. As necessary, the hard carbon coating 3a formed at the outer periphery and the hard carbon coating 3b formed at the side surfaces were polished such that the surface roughness thereof was adjusted to the similar level of each base 12 before the film formation.

### (Composition of Hard Carbon Coating)

The contents of hydrogen and carbon of the hard carbon coatings 3a, 3b were determined by RBS/HFS and SIMS as described above. As the hard carbon coatings 3a, 3b formed on the outer periphery of the piston ring are not flat, the RBS/HFS cannot be measured just as it is. Then, as a standard sample, a flat test piece that was mirror polished (quenched SKH 51 material disc, diameter of 24 x thickness of 4 (mm)) was mounted to the jig 120 together with each base 12 to form the hard carbon coating. Specifically, the standard sample was disposed on the jig 120 such that the center of the mirror polished surface of the standard sample faces the same direction at the same position of the outer periphery of the piston ring, and the film is formed by rotating the jig 120.

The compositions (the content percentages of hydrogen and carbon (hydrogen (at%)/carbon (at%))) of the hard carbon coatings 3a, 3b of the standard sample were evaluated by the RBS/HFS.

Next, by the SIMS, a secondary ion intensity ratio (hydrogen (count/sec)/carbon (count/sec)) of hydrogen and carbon of the hard carbon coating formed on the standard sample was measured. A relational expression (calibration curve) between the value of (hydrogen/carbon) evaluated by the above-described RBS/HFS and the value of (hydrogen/carbon) evaluated by the SIMS was determined by a secondary regression curve using the least-squares method.

For each sample in Examples and Comparative Examples, the ratio of (hydrogen/carbon) of the hard carbon coating 3 was measured by the SIMS, and was converted into an atom ratio equivalent to the RBS/HFS by the calibration curve.

Each sample in Examples and Comparative Examples was analyzed for the elements other than hydrogen and carbon by the EDX to calculate a ratio of carbon and other element based on the carbon content(at %). This confirms that each hard carbon coating 3 in Examples 1 to 4 and Comparative Examples 1 and 2 contained no hydrogen and 98 atom% or more of carbon.

### (Morphology of Hard Carbon Coating)

As described above, the carbon hard coating was evaluated whether or not the carbon hard coating has the columnar structure. When the carbon hard coating has the columnar structure, the angle θ was calculated.

### (Comparative Example 3)

To a plasma CVD film formation apparatus equipped with a hot cathode PIG plasma gun, the jig 120 similar to that as described above was attached. To the jig, each base 12 was mounted similar to Example 1, and the hard carbon coating was formed by feeding Ar and C₂H₂ using the plasma CVD method. The composition of the hard carbon coating was analyzed similarly as described above. As a result, the hard carbon coating contained 35.8 atom% of hydrogen and 63.7 atom% of carbon.

### (Comparative Example 4)

The intermediate layer 16 was formed on the surface of the base 12 similar to Example 1. Next, Ar was fed to the vacuum chamber 40 upon the formation of the hard carbon coating, and the pressure of the atmosphere was adjusted to 0.5 Pa, thereby forming the hard carbon coating similar to Example 1. It was confirmed that the hard carbon coating 3 contained no hydrogen and contained 98 atom% or more of carbon.

### (Evaluation)

The engine test was performed using each piston ring in Examples and Comparative Examples. In the engine test, a four-cylinder gasoline engine was used. Each piston ring was mounted to a predetermined position of the aluminum alloy piston. The engine operating conditions were as follows:
Revolution number: 5700 rpm
Engine oil: 5W-20SL (oil temperature: 90°C)
Load: full load
Operating time: 450 h

### (Evaluation of exposed under layer)

After the engine test, the piston ring was detached, and the hard carbon coating 3a on the outer periphery of the piston ring was visually observed using a magnifying glass. When the under layer (intermediate layer 16) was exposed in a length of 5 mm or more, it was judged as "bad". Others were judged as "good". The good judgement of the exposed under layer refers that the hard carbon layer coating 3a maintains the abrasion resistance for a long period of time.

### (Adhesion of aluminum)

Next, the hard carbon coating 3b on the side surface of the piston ring was visually observed using a magnifying glass to judge whether or not aluminum at the piston side was adhered to the coating. When it was recognized that aluminum was adhered to the coating at a maximum outer diameter of 0.5 mm or more, it was judged as "bad". Others were judged as "good". The good judgement of the aluminum adhesion refers that the hard carbon layer coating 3b inhibits the adhesion of aluminum of the piston ring groove.

### (Abrasion of piston ring groove)

The piston was removed and cut along an axial direction after the engine test. An abrasion depth was measured at a center of a cut surface of the piston ring groove in a width direction (up and down direction). When the abrasion depth was 5 µm or less, it was judged as "good". When the abrasion depth exceeded 5 µm, it was judged as "bad". The good judgement refers that the hard carbon layer coating 3b inhibits the adhesion of aluminum of the piston ring groove.

The results are shown in Table1.

**[Table 1]**

| | Film formation conditions | | | Hard carbon coating | | | | | Evaluation | | |
|---|---|---|---|---|---|---|---|---|---|---|---|
| | Film formation method | *φ* (°) | Pressure of atmosphere (Pa) | Comporision (atom%) | | Coating morphology | | | Outer periphery | Side surface | |
| | | | | Hydrogen | Carbon | Outer periphery | Side surface | Angle of columnar structure θ (°) | Under layer exposure | Adhesion of aluminum | Abrasion of piston ring groove |
| Example 1 | Arc ion plating method | 50 | 0.05 | 1.1 | 98.7 | No columnar structure | Columnar structure | 11.3 | Good | Good | Good |
| Example 2 | Arc ion plating method | 60 | 0.02 | 0.2 | 99.5 | No columnar structure | Columnar structure | 25.2 | Good | Good | Good |
| Example 3 | Arc ion plating method | 70 | <0.003 | 0.5 | 98.8 | No columnar structure | Columnar structure | 28 | Good | Good | Good |
| Example 4 | Arc ion plating method | 80 | 0.01 | 0.4 | 99.1 | No columnar structure | Columnar structure | 29 | Good | Good | Good |
| Comparative Example 1 | Arc ion plating method | 90 | <0.003 | 1.2 | 98.2 | No columnar structure | Columnar structure | 36.1 | Good | Bad | Bad |
| Comparative Example 2 | Arc ion plating method | 40 | 0.004 | 0.9 | 98.1 | No columnar structure | Columnar structure | 8.2 | Good | Good | Bad |
| Comparative Example 3 | Plasma CVD method | 90 | 0.5 | 35.8 | 63.7 | No columnar structure | Columnar structure | 3 | Bad | Bad | Bad |
| Comparative Example 4 | Arc ion plating method | 50 | 0.5 | 1.0 | 98.8 | Columnar structure | Columnar structure | 7.7 | Bad | Bad | Bad |

As apparent from Table 1, in Examples where the hard carbon coating containing no hydrogen was formed, the hard carbon coating formed at the outer periphery had no columnar structure, and the hard carbon coating formed on the side surface had a columnar structure extending to a direction intersecting with the side surface, different coating characteristics could be added to the outer periphery and the side surface of the piston ring, abrasion resistance was high, and the adhesion of aluminum of a piston ring groove could be inhibited.

On the other hand, in Comparative Example 1 where the columnar structure of the hard carbon coating formed at the side surface had the angle θ tilted at the outer periphery side in the normal n direction of exceeding 30 degrees, the adhesion of aluminum of the piston ring groove could not be inhibited.

In Comparative Example 2 where the columnar structure of the hard carbon coating formed at the side surface had the angle θ of less than 10 degrees, aluminum of the piston ring groove was not adhered to, but the abrasion of the piston ring groove proceeded. It is conceivable that as the axis center Ax of the jig 120 was tilted at 40 degrees in Comparative Example 2, a plurality of the bases 12 formed the obstacle upon the film formation, the ion flow was blocked frequently, and the contribution of the ions having high energy to the coating formation was decreased, thereby lowering the strength of the coating. Further, it is conceivable that even though aluminum is slightly adhered due to the low strength of the coating, aluminum drops off and the adhesion of aluminum does not further proceed. In addition, it is conceivable that abrasion powder (including aluminum) generated by sliding with the piston ring groove promotes the abrasion of the piston ring groove in Comparative Example 2.

In Comparative Example 3 where the hard carbon coating was formed by the plasma CVD method, as hydrogen contained in the coating exceeded 2 atom%, the abrasion resistance was poor.

In Comparative Example 4 where the pressure exceeded 5 x 10⁻² Pa upon the film formation, the outer periphery of the hard carbon coating had insufficient abrasion resistance, the abrasion proceeded due to slide with the cylinder liner inner wall, and the under layer was exposed. Also, the abrasion of the piston ring groove proceeded, resulting in the adhesion of aluminum.

It is conceivable that the ion flow is frequently collided with gas atoms (or molecules) due to the high pressure, the ion flow loses most of initial energy, carbon in the outer periphery of the hard carbon coating cannot be strongly bonded on the base, and the abrasion resistance of the coating becomes insufficient in Comparative Example 4. In addition, it is conceivable that as the energy of the ion flow is low, the strength of the hard carbon coating at the side surface is also lowered.

### Description of Symbols

3 hard carbon coating
3a hard carbon coating formed at outer periphery
3b hard carbon coating formed at side surface
10 piston ring
12 base (of piston ring)
12a outer periphery of base
12b1, 12b2 side surfaces of base
n normal line
θ angle between columnar structure extending direction and side surface normal direction

## Claims

1. A piston ring (10) mounted to a piston made of an aluminum alloy that slides with a cylinder liner containing Fe as a main component, comprising:
hard carbon coatings (3a, 3b) containing a hydrogen content of 2 atom % or less when a total amount of all elements configuring the hard carbon coating (3a, 3b) is taken as 100 atom % formed on an outer periphery (12a) and at least one side surface (12b1,12b2), **characterized in that**
the hard carbon coating (3a) formed on the outer periphery (12a) has no columnar structure as determined on a scanning electron microscope image as described in paragraph [21-22] of the description, and the hard carbon coating (3b) formed on the side surface (12b1,12b2) has a columnar structure extending to a direction intersecting with the side surface (12b1,12b2), and tilted at 10 to 30 degrees to the outer periphery (12a) from a normal direction of the side surface (12b1,12b2).

2. The piston ring according to claim 1, wherein the hard carbon coating (3a, 3b) contains 98 atom% or more of carbon.

3. A method of producing a piston ring (10), comprising:
forming hard carbon coatings (3a, 3b) on an outer periphery (12a) and at least one side surface (12b1,12b2) of the piston ring (10) using an arc evaporation source including a carbon cathode by an arc ion plating method,
wherein the side surface (12b1,12b2) of the piston ring (10) and an ion flow from the arc evaporation source are disposed to have an angle therebetween of 10 to 40 degrees, and the hard carbon coatings (3a, 3b) are formed without feeding gas from outside excluding an inert gas, and wherein a pressure upon the formation of the hard carbon coatings (3a, 3b) is 5 x 10⁻² Pa or less.

## Patentansprüche

1. Kolbenring (10), der an einem aus einer Aluminiumlegierung hergestellten Kolben befestigt ist, der mit einer Zylinderlaufbuchse gleitet, die Fe als eine Hauptkomponente enthält, umfassend:
harte Kohlenstoffbeschichtungen (3a, 3b), die einen Wasserstoffgehalt von 2 Atom-% oder weniger enthalten, wenn eine Gesamtmenge aller Elemente, die die harte Kohlenstoffbeschichtung (3a, 3b) konfigurieren, als 100 Atom-% genommen wird, gebildet an einem äußeren Umfang (12a) und mindestens einer Seitenfläche (12b1, 12b2), **dadurch gekennzeichnet dass**
die harte Kohlenstoffbeschichtung (3a), die an dem äußeren Umfang (12a) gebildet ist, keine Kolumnarstruktur aufweist, wie auf einem Rasterelektronenmikroskop-Bild, wie in Paragraph [21-22] der Beschreibung beschrieben, bestimmt, und dass die harte Kohlenstoffbeschichtung (3b), die an der Seitenfläche (12b1, 12b2) gebildet ist, eine Kolumnarstruktur aufweist, die sich in eine Richtung erstreckt, die sich mit der Seitenfläche (12b1, 12b2) schneidet, und die um 10 bis 30 Grad zu dem äußeren Umfang (12a) von einer Normalrichtung der Seitenfläche (12b1, 12b2) geneigt ist.

2. Kolbenring nach Anspruch 1, wobei die harte Kohlenstoffbeschichtung (3a, 3b) 98 Atom-% oder mehr Kohlenstoff enthält.

3. Verfahren zum Herstellen eines Kolbenrings (10), umfassend:
Bilden von harten Kohlenstoffbeschichtungen (3a, 3b) an einem äußeren Umfang (12a) und mindestens einer Seitenfläche (12b1, 12b2) des Kolbenrings (10) unter Verwendung einer Lichtbogenverdampfungsquelle, die eine Kohlenstoffkathode einschließt, durch ein Lichtbogenionenplattierungsverfahren, wobei die Seitenfläche (12b1, 12b2) des Kolbenrings (10) und ein Ionenfluss von der Lichtbogenverdampfungsquelle so angeordnet sind, dass sie einen Winkel von 10 bis 40 Grad dazwischen aufweisen, und die harten Kohlenstoffbeschichtungen (3a, 3b) ohne Zufuhr von Gas von außen unter Ausschluss eines Inertgases gebildet werden und wobei ein Druck bei der Bildung der harten Kohlenstoffbeschichtungen (3a, 3b) 5 × 10⁻² Pa oder weniger beträgt.

## Revendications

1. Segment de piston (10) monté sur un piston composé d'un alliage d'aluminium qui coulisse avec une chemise de cylindre contenant du Fe en tant que composant principal, comprenant :
des revêtements de carbone dur (3a, 3b) contenant une teneur en hydrogène de 2 % d'atomes ou moins lorsqu'une quantité totale de tous les éléments configurant le revêtement de carbone dur (3a, 3b) est prise comme 100 % d'atomes formés sur une périphérie extérieure (12a) et au moins une surface latérale (12b1, 12b2),
**caractérisé en ce que**
le revêtement de carbone dur (3a) formé sur la périphérie extérieure (12a) n'a pas de structure colonnaire telle que déterminé sur une image de microscope électronique à balayage telle que décrite au paragraphe [21-22] de la description, et le revêtement de carbone dur (3b) formé sur la surface latérale (12b1, 12b2) a une structure colonnaire s'étendant dans une direction coupant la surface latérale (12b1, 12b2) et inclinée à 10 à 30 degrés vers la périphérie extérieure (12a) depuis une direction perpendiculaire de la surface latérale (12b1, 12b2).

2. Segment de piston selon la revendication 1, dans lequel le revêtement de carbone dur (3a, 3b) contient 98% d'atomes de carbone ou plus.

3. Procédé de production d'un segment de piston (10), comprenant :
la formation de revêtements de carbone dur (3a, 3b) sur une périphérie extérieure (12a) et au moins une surface latérale (12b1, 12b2) du segment de piston (10) en utilisant une source d'évaporation d'arc comprenant une cathode de carbone par un procédé de placage ionique par arc,
dans lequel la surface latérale (12b1, 12b2) du segment de piston (10) et un flux ionique provenant de la source d'évaporation d'arc sont disposés pour avoir un angle entre eux de 10 à 40 degrés, et les revêtements de carbone dur (3a, 3b) sont formés sans amener de gaz depuis l'extérieur à l'exception d'un gaz inerte, et dans lequel une pression sur la formation des revêtements de carbone dur (3a, 3b) est de 5 x 10⁻² Pa ou moins.
